# FASCICULE DE BREVET EUROPEEN

(11) **EP 4 523 247 B1**
(45) Date de publication et mention de la délivrance du brevet: **15.04.2026**
(21) Numéro de dépôt: 23726042.7
(22) Date de dépôt: 10.05.2023
(51) Int. Cl.: H01L 21/67, H01L 21/687

(54) **ROUE D'IMPLANTATION POUR FORMER UN PLAN DE FRAGILISATION DANS UNE PLURALITÉ DE PLAQUETTES DONNEUSES**
IMPLANTATIONSRAD ZUR BILDUNG EINER SCHWÄCHUNGSEBENE IN EINER VIELZAHL VON SPENDERWAFERN
IMPLANTATION WHEEL FOR FORMING A PLANE OF WEAKNESS IN A PLURALITY OF DONOR WAFERS

(30) Priorité: 11.05.2022 FR 2204475
(43) Date de publication de la demande: 19.03.2025
(73) Titulaire: SOITEC, 38190 Bernin (FR)
(72) Inventeur: BEN MOHAMED, Nadia, 38190 Bernin (FR); PETIT, Olivier, 38190 Bernin (FR); COLAS, Franck, 38190 Bernin (FR); RADISSON, Damien, 38190 Bernin (FR); RIEUTORD, François, 38190 Bernin (FR)
(74) Mandataire: IP Trust
(86) Numéro de dépôt international: PCT/EP2023/062394
(87) Numéro de publication internationale: WO 2023/217845

(56) Documents cités:
- US-A1- 2014 235 007
- US-A1- 2015 275 364
- US-A1- 2015 340 254
- US-A1- 2016 300 753
- US-A1- 2017 067 162
- US-A1- 2020 013 643

## Description

### DOMAINE DE L'INVENTION

L'invention tombe dans le domaine de l'implantation ionique, et porte plus particulièrement sur un équipement d'implantation ionique adapté à la formation d'un plan de fragilisation dans une pluralité de plaquettes donneuses dans le cadre d'un procédé de transfert de couche mince mise en œuvre selon la technologie Smart Cut^{®}.

### ARRIERE PLAN TECHNOLOGIQUE DE L'INVENTION

Le document US2020186117 propose de reporter une couche mince d'un matériau ferroélectrique sur un support en mettant en œuvre la technologie Smart Cut^{®}. Le support présente un coefficient de dilatation thermique différent de celui du matériau ferroélectrique constituant la couche mince reportée. Il peut notamment s'agir d'un support en silicium.

La technologie Smart Cut^{®} prévoit de définir la couche mince par introduction d'espèces légères dans un substrat donneur, les espèces légères se concentrant dans un plan de fragilisation situé à la profondeur de pénétration moyenne des espèces. Le substrat donneur est ensuite assemblé au support et le report de la couche s'effectue par détachement de la couche mince au niveau du plan de fragilisation. Dans le cas d'une couche en un matériau ferroélectrique et/ou piézoélectrique et lorsque les espèces légères sont choisies parmi les ions d'hydrogène et les ions d'hélium, ce détachement est provoqué par une élévation modeste de la température à laquelle est soumis l'assemblage, de l'ordre de 170°C.

Pour limiter les contraintes qui se développent dans l'assemblage lorsque celui-ci est élevé en température, notamment lors de l'étape de détachement qui vient d'être évoquée, le document US2020186117 propose de constituer le substrat donneur de l'assemblage d'une couche épaisse formée du matériau ferroélectrique et d'un substrat manipulateur, le coefficient de dilatation thermique du substrat manipulateur étant similaire à celui du substrat support. Un tel substrat donneur est désigné hétéro-structure donneuse dans la suite de cette description.

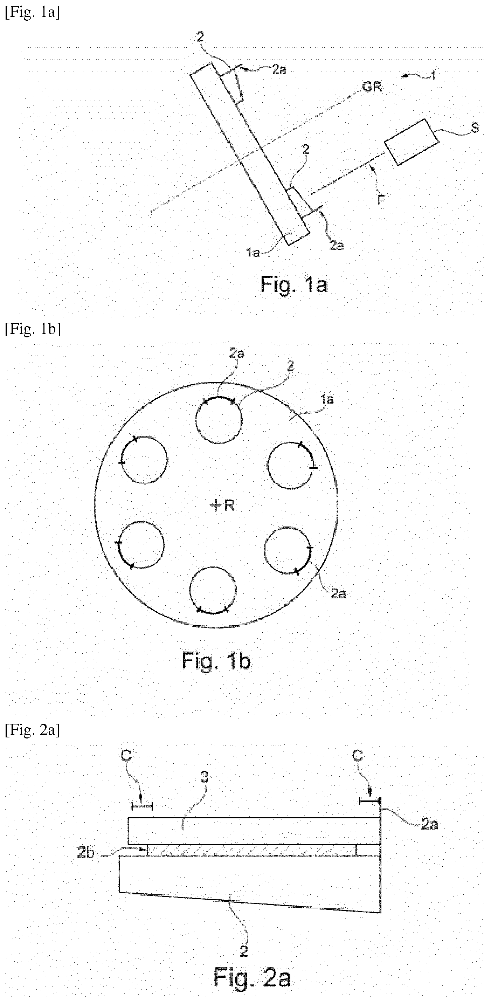

L'étape d'introduction des espèces légères dans l'hétérostructure donneuse peut être conduite par l'intermédiaire d'un équipement d'implantation ionique. Les figures 1a et 1b représentent une vue schématique d'une configuration connue d'un tel équipement.

Une roue 1 d'un équipement d'implantation ionique comprend un disque 1a disposé dans un plan présentant un angle faible par rapport à la verticale (typiquement entre 5° et 10°). La roue porte sur une de ses faces une pluralité de supports 2 pour respectivement recevoir une pluralité d'hétérostructures donneuses. Le disque est entrainé en rotation autour d'un axe R perpendiculaire et passant par son centre, à une vitesse pouvant atteindre 1200 tours/minutes. Les supports présentent des cales 2a contre lesquelles les bords des hétérostructures donneuses viennent en appui lorsque la roue est entrainée en rotation à grande vitesse. Lors de cette rotation, les faces exposées des hétérostructures donneuses sont successivement disposées en vis-à-vis d'une source S d'ions d'espèces légères (par exemple des ions d'hydrogène ou d'hélium) accélérés à une énergie donnée et conformés en un faisceau d'ions F définissant un courant d'implantation. L'énergie d'implantation, le courant d'implantation et la durée d'exposition au faisceau forment, pour une espèce implantée donnée, les conditions de l'implantation. L'énergie définit la profondeur de pénétration moyenne des ions, et le courant définit pour une durée d'exposition donnée la dose implantée. Le faisceau F scanne toutes les surfaces exposées des hétérostructures donneuses.

De tels équipements d'implantation ionique sont par exemple connus des documents US20070158583A1, US4832781 ou US5040484.

La puissance apportée par les ions pénétrant dans une hétérostructure donneuse tend à échauffer cette hétérostructure. Pour éviter un échauffement excessif, le disque principal et les supports de la roue sont parcourus de conduits dans lesquels circule un fluide de refroidissement, typiquement de l'eau. Les supports contre lesquels les hétérostructures donneuses sont plaquées forment des dissipateurs thermiques, il est donc important que ces hétérostructures soient bien en contact intime avec leur support pour favoriser l'évacuation de chaleur. Il est ainsi généralement prévu de munir ces supports (qui peuvent être formés d'un bloc d'aluminium pour aider à cette dissipation) d'une partie superficielle en élastomère qui permet d'assurer cette intimité de contact.

On cherche généralement à réduire la durée de l'étape d'implantation en augmentant le courant du faisceau et, ce faisant, on tend à accroitre la puissance apportée aux hétérostructures donneuses et donc leur température.

En cherchant à augmenter le courant d'implantation d'une hétérostructure donneuse présentant une couche épaisse ferroélectrique, la Demanderesse a observé l'exfoliation de 1a couche mince pendant l'étape d'implantation elle-même. Ce phénomène non désiré, puisqu'il rend l'étape de report de couche impossible, a été obtenu malgré tous les soins apportés pour refroidir les supports du disque d'implantation au cours de cette étape.

### OBJET DE L'INVENTION

Un but de l'invention est de proposer une roue d'implantation permettant de remédier à ce problème. Plus particulièrement, un but de l'invention est de proposer une roue d'implantation particulièrement adaptée à l'implantation d'une hétérostructure donneuse sur une large gamme de conditions d'implantation et sans provoquer l'exfoliation prématurée de l'hétérostructure donneuse.

### BREVE DESCRIPTION DE L'INVENTION

En vue de la réalisation de ce but, l'objet de l'invention propose un équipement d'implantation ionique comprenant une source d'ions et une roue d'implantation selon la revendication indépendante 1.

Selon l'invention, chaque surface d'accueil de la pluralité de supports de plaquette présente une forme bombée, la forme bombée étant choisie pour correspondre à la forme de la plaquette donneuse lorsque celle-ci se déforme sous l'effet de la température.

Selon d'autres caractéristiques avantageuses et non limitatives de cet aspect de l'invention, prises seules ou selon toute combinaison techniquement réalisable :
- chaque surface d'accueil comprend une couche d'élastomère superficielle sur laquelle repose la face arrière d'une plaquette donneuse, la couche d'élastomère superficielle présentant une dimension au moins égale à celle de la face arrière de la plaquette donneuse afin de permettre la mise en contact de toute l'étendue de la face arrière de 1a plaquette donneuse avec le support de plaquette ;
- la couche d'élastomère superficielle présente une épaisseur variable, cette épaisseur variable définissant 1a forme bombée du support de plaquette ;
- la forme bombée se présente sous 1a forme d'un évidemment concave ou sous la forme d'un dôme convexe ;
- l'évidemment concave ou le dôme convexe présente une hauteur comprise entre 0,1mm et 5mm.
- la roue d'implantation présente un axe de symétrie définissant un axe de rotation et chaque surface d'accueil de la pluralité de supports de plaquette est orientée vers l'axe de rotation de sorte qu'une composante normale à la surface d'accueil de la force centrifuge s'applique à la plaquette donneuse lors de la rotation de la roue et presse celle-ci contre la surface d'accueil ;
- chaque support de plaquette est muni d'une cale permettant de retenir une plaquette donneuse en s'opposant à une composante coplanaire à la surface d'accueil de la force centrifuge s'appliquant à la plaquette donneuse lors de la rotation de la roue ;
- la surface d'accueil de chaque support de plaquette présente une élévation maximale au niveau de 1a cale ;
- chaque support de plaquette est muni d'un pion rétractable ;
- chaque support de plaquette est muni d'au moins un clip permettant de positionner et retenir une plaquette contre la cale :
- la surface d'accueil de chaque support de plaquette présente une élévation, l'élévation de la surface d'accueil, par rapport au pied du support, présente un maximaum au niveau de la cale.

### BREVE DESCRIPTION DES FIGURES

D'autres caractéristiques et avantages de l'invention ressortiront de la description détaillée de l'invention qui va suivre en référence aux figures annexées sur lesquelles :
[Fig.1a]
   La [Fig.1a] représente une vue schématique une configuration d'un équipement d'implantation ionique de l'état de la technique et conforme à l'invention ;
[Fig.1b]
   La [Fig.1a] représente de manière schématique, en vue de face, une roue d'implantation selon l'état de la technique et conforme à l'invention ;
[Fig.2a]
   [Fig.2b]

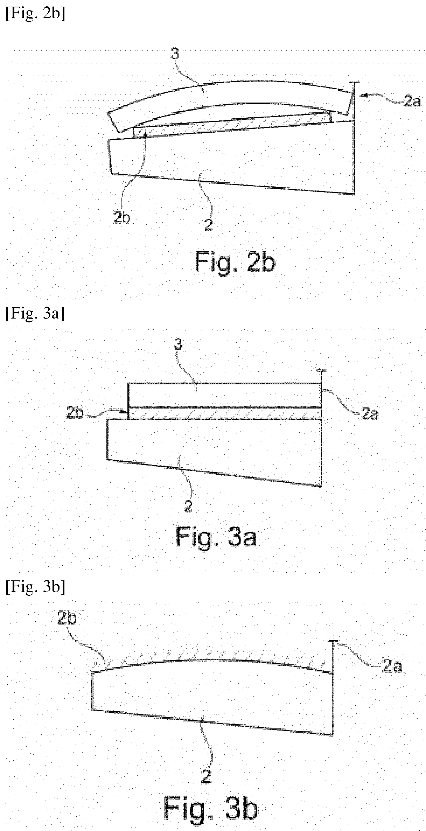

   Les figures 2a et 2b représentent une plaquette donneuse disposée sur un support de plaquette de l'état de la technique respectivement avant et pendant une étape d'implantation ionique ;
[Fig.3a]
   [Fig.3b]
   [Fig.3c]
   [Fig.3d]
   [Fig.3e]

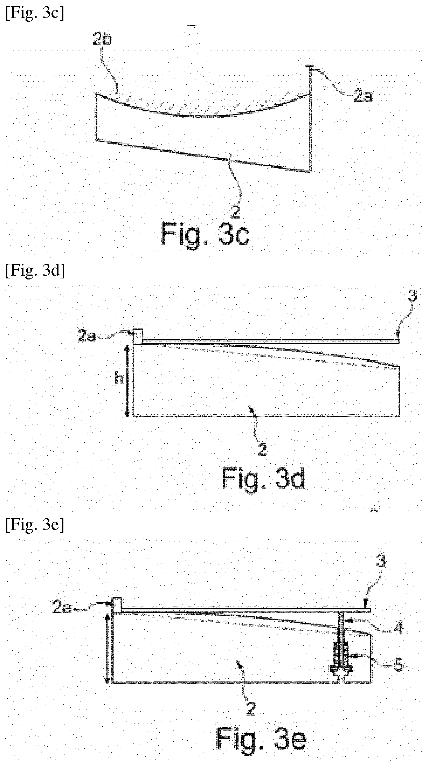

   Les figures 3a, 3b, 3c, 3d et 3e représentent des supports de plaquette d'une roue d'implantation conforme à l'invention.

### DESCRIPTION DETAILLEE DE L'INVENTION

L'expression « coefficient de dilatation thermique » employée dans la suite de cette description en relation à une couche ou à un substrat fait référence au coefficient de dilatation selon une direction définie dans le plan principal définissant cette couche ou ce substrat. Si le matériau est anisotrope, la valeur du coefficient retenue sera celle de plus grande amplitude. La valeur du coefficient est celle mesurée à température ambiante.

### Expériences préparatoires

Pour comprendre l'origine de ce phénomène d'exfoliation présenté en introduction de cette demande, la Demanderesse a mené une série d'expériences exploratoires. Au cours de ces expériences, on a mesuré le profil spatial de température d'une hétérostructure donneuse qui se développe dans cette hétérostructure au cours d'une étape d'implantation dans des conditions visant à former un plan de fragilisation selon la technologie Smart Cut^{®}. Plus précisément un équipement d'implantation ionique de l'état de la technique a été employé pour introduire une dose d'hydrogène de 3.0 10^16 at/cm^2 à un courant d'implantation de 16mA et à une énergie de 137 keV environ. L'hétérostructure donneuse était formée d'une couche d'un matériau piézoélectrique, dont l'épaisseur était comprise entre 15-20 microns, assemblée à une plaquette de silicium. La température de l'hétérostructure a été mesurée en répartissant sur sa face avant, c'est-à-dire sur la face exposée au faisceau d'ions, une pluralité de patchs adhésifs thermosensibles recouverts d'un film de kapton^{®}. Chaque patch présente un indicateur visuel de la température maximale à laquelle il a été exposé. En disposant ces patchs sur une face de la plaquette, et en relevant à l'issue de l'expérience les indicateurs visuels de chaque patch, on peut estimer le profil spatial de température qui s'est développé dans la plaquette au cours de l'étape d'implantation.

La même expérience a été reproduite, dans les mêmes conditions d'implantation, en appliquant cette fois l'étape d'implantation à une plaquette de silicium massive, identique à la plaquette formant le substrat manipulateur de l'hétéro structure donneuse. Le tableau ci-dessous présente les résultats de ces expériences.

| | Température au bord | Température au centre |
|---|---|---|
| Plaquette silicium | 54-64°C | 46-49°C |
| Hétéro-structure | 132-166°C | >166°C |

On observe sur les résultats issus de ces expériences, que la température à laquelle s'est élevée une hétérostructure donneuse est étonnamment très supérieure à celle à laquelle s'est élevée la simple plaquette de silicium. On note que cette température, qui peut atteindre et même dépasser les 160°C s'approche, voire même atteint, la température d'exfoliation, cette température étant proche de celle provoquant le détachement d'une couche mince ferroélectrique dans le cadre de l'application de la technologie Smart Cut^{®}, comme cela a été rappelé en introduction. On comprend donc pourquoi, l'exfoliation de la couche mince peut être observée pendant l'étape d'implantation elle-même.

On observe par ailleurs un profil spatial de température opposé dans le cas de l'implantation d'une plaquette de silicium (le centre s'élevant à une température plus faible que le bord) que dans le cas de l'implantation d'une hétérostructure donneuse (le bord s'élevant à une température plus faible que le centre).

En cherchant à interpréter ces résultats, la demanderesse a observé que dans l'équipement d'implantation de l'état de la technique employé pour mener ces expériences, la partie superficielle en élastomère des supports de la roue d'implantation, qui assure le contact thermique entre un support et la plaquette implantée, ne s'étendait pas entièrement sous toute la face arrière de cette plaquette. Comme cela est visible sur la [Fig.2a] qui représente une hétérostructure donneuse 3 disposée sur un support de plaquette avant le début de l'étape d'implantation, cette partie superficielle en élastomère 2b de forme circulaire et sur laquelle une plaquette 3 également circulaire est centrée, présente un diamètre plus petit que celui de la plaquette. Une couronne périphérique C de la face arrière de la plaquette (de quelques millimètres) n'est donc pas en contact intime avec cette couche superficielle élastomère 2b, et la chaleur qui s'y accumule au cours de l'étape d'implantation ne peut s'évacuer. Cette chaleur tend donc à diffuser vers une portion centrale de la plaquette 3 et élève donc la température moyenne de celle-ci. S'agissant d'une hétérostructure donneuse 3 formée, comme on l'a rappelé en introduction, d'une couche épaisse en matériau ferroélectrique et d'un substrat manipulateur, présentant des coefficients de dilatation différents, l'élévation de 1a température moyenne tend à déformer l'hétérostructure donneuse 3, qui prend une forme convexe pour accommoder ces contraintes. Cette situation est illustrée sur la [Fig.2b] qui représente l'hétérostructure donneuse 3 déformée par son élévation de température qui intervient au cours de l'étape d'implantation. Cette forme convexe tend à éloigner la partie centrale de l'hétérostructure du support de la roue d'implantation, et préserver un contact au niveau d'un cercle périphérique uniquement comme cela est bien visible sur la [Fig.2b]. Les contraintes générées par la différence de coefficients de dilatation sont plus importantes que la force centrifuge qui tend à maintenir plaquée l'hétérostructure en contact intime sur la partie superficielle élastomère du support. Ce contact intime perdu, la chaleur qui s'accumule dans l'hétéro structure donneuse 3 au cours de l'implantation ne peut plus s'évacuer avec la même efficacité, ce qui tend à amplifier le phénomène de déformation de l'hétéro structure et, par effet d'emballement thermique, provoque un accroissement de sa température jusqu'à atteindre localement au moins la température d'exfoliation. On comprend également à travers cette explication la raison pour laquelle la partie centrale de l'hétérostructure donneuse 3, qui n'est plus en contact avec le support 2, tend à atteindre une température plus importante que le bord qui reste quant à lui en contact avec ce support 2.

### Roue d'implantation améliorée

Cette section de la description propose une roue d'implantation améliorée visant à prévenir l'élévation excessive en température d'une plaquette donneuse, et notamment une hétérostructure donneuse, lorsque celle-ci est exposée à un faisceau d'ions d'espèces légères (typiquement de l'hydrogène ou d'hélium) en vue d'y former un plan de fragilisation.

Cette roue est particulièrement utile lorsque la plaquette donneuse est une hétérostructure donneuse, constituée d'une couche épaisse disposée sur un substrat manipulateur, les coefficients de dilatation thermique du substrat manipulateur et de la couche épaisse étant distincts l'un de l'autre, par exemple d'au moins 5%. La roue peut néanmoins être exploitée pour tout type de plaquette donneuse.

Similairement à ce qui a été exposé en relation avec la description des figures 1a et 1b, la roue comprend un disque principal 1a et une pluralité de supports de plaquette 2 disposés, par exemple annulairement, sur une face du disque principal 1. Chaque support de plaquette 2 présente une surface d'accueil destinée à recevoir une face dite « arrière » d'une plaquette donneuse. Le support de plaquette 2 est formé d'une partie massive métallique, par exemple en aluminium qui définit la surface d'accueil. Cette surface d'accueil est avantageusement munie, au moins partiellement, d'une couche d'élastomère superficielle. Cette couche peut présenter une rugosité permettant de limiter le glissement de la plaquette donneuse, de maintenir un contact intime avec la face arrière de cette plaquette et permettre une évacuation efficace de la chaleur qui est susceptible de s'y accumuler au cours de l'étape d'implantation ionique. Le matériau constituant cette couche est donc choisi pour être un bon conducteur thermique, afin de permettre l'écoulement de la chaleur, vers le support de plaquette. On peut prévoir de charger ce matériau de particules conductrices thermiques, par exemple à base de carbone ou d'alumine, pour favoriser le caractère conducteur thermique de la couche. La couche d'élastomère superficielle peut être amenée sur la partie métallique du support de plaquette par dépôt, par exemple à l'aide d'un procédé de revêtement par rotation (ou « spin coating » selon l'expression anglo-saxonne usuellement employée dans le domaine). Alternativement, la couche peut être préparée sous la forme d'un film adhésif, découpée aux dimensions de la partie métallique du support de plaquette 2 pour y être placée sur la surface d'accueil.

Le support 2 et le disque principal 1 peuvent être l'un et/ou l'autre refroidi(s) par un circuit de refroidissement, afin d'évacuer la chaleur provenant des plaquettes donneuses pendant toute la durée de l'étape d'implantation.

La roue 1 présente un axe de symétrie R (perpendiculaire aux faces du disque principal composant la roue et passant par son centre) qui définit l'axe de rotation de la roue. Au cours d'une étape d'implantation, la roue 1 est mise en mouvement de rotation autour de cet axe R (complétée d'un mouvement de balayage), afin d'exposer successivement les plaquettes donneuses maintenues sur leur support au faisceau d'ions légers produit par la source de l'équipement d'implantation.

Chaque surface d'accueil de la pluralité de supports de plaquette 2 est orientée vers l'axe de rotation de sorte qu'une composante normale à la surface d'accueil de la force centrifuge s'applique à la plaquette donneuse lors de la rotation de la roue 1. Cette force tend à presser la plaquette donneuse et la maintenir contre la surface d'accueil. Pour permettre d'orienter la surface d'accueil d'un support vers l'axe de rotation de la roue sur laquelle ce support repose, celui-ci présente une épaisseur plus réduite du coté disposé vers le centre de la roue que du côté opposé au centre de la roue, comme cela est bien visible sur la [Fig.3a].

Chaque support de plaquette 2 est muni d'une cale 2a, typiquement une cale latérale épousant la forme d'une plaquette donneuse, permettant de retenir cette plaquette en s'opposant à une composante coplanaire à la surface d'accueil de la force centrifuge s'appliquant à la plaquette lors de la rotation de la roue.

Enfin, et comme cela est bien connu en soi, chaque support de plaquette est muni d'au moins un clip (non représenté) permettant de positionner précisément une plaquette donneuse sur son support et maintenir cette plaquette contre la cale lorsque la roue ne tourne pas.

Selon un premier mode de mise en œuvre représenté sur la [Fig.3a], la couche élastomère 2b présente une dimension au moins égale à celle de la face arrière de la plaquette donneuse 3 afin de permettre la mise en contact de toute l'étendue de cette face arrière avec le support de plaquette 2. Avanatgeusement, la couche élastomère 2b présente une dimension strictement supérieure à celle de la face arrière de la plaquette donneuse 3.

De la sorte, on évite d'accumuler un excès de chaleur au cours de l'étape d'implantation, dans une couronne périphérique C de la plaquette qui n'est donc pas en contact intime avec la couche élastomère 2b, comme cela est le cas dans la configuration de l'état de la technique. On prévient ou retarde donc l'enclenchement du phénomène d'emballement qui conduit, par élévation progressive de la température moyenne de la plaquette donneuse 3, à déformer cette plaquette et à perdre le contact intime entre sa face arrière et la couche élastomère. On peut donc mener cette étape d'implantation sans élever la température moyenne de cette plaque au-delà de la température critique qui provoque l'exfoliation d'une partie au moins de la couche mince. Corolairement on peut donc appliquer des conditions d'implantation (définies principalement, pour rappel, par le courant d'implantation, l'énergie d'implantation et la durée d'exposition au faisceau d'ions) sur une gamme plus étendue qu'à l'aide d'un équipement de l'état de la technique. On peut notamment réduire la durée d'exposition au faisceau, et donc la durée de cette étape d'implantation, en augmentant le courant d'implantation, et sans risquer de provoquer le phénomène d'exfoliation.

Selon un deuxième mode de mise en œuvre dont on trouvera des exemples de réalisation sur les figures 3b et 3c, chaque surface d'accueil de la pluralité de supports 2 de plaquette donneuse présente une forme bombée, la forme bombée étant choisie pour correspondre à la forme, convexe ou concave, de la plaquette lorsque celle-ci se déforme sous l'effet de la température.

En conférant cette forme bombée du support 2 qui tend à épouser la forme de la plaquette donneuse lorsque celle-ci monte en température lors de l'étape d'implantation, on préserve le contact intime entre la face arrière de cette plaquette et la surface d'accueil du support, on assure l'évacuation de la chaleur par diffusion dans le support 2, et on limite ainsi l'élévation de la température lors de l'étape d'implantation.

On note que lors du placement initial de la plaquette donneuse qui est plane, non déformée, à température ambiante sur un tel support bombé, le contact intime n'est pas obtenu sur toute l'étendue de la plaquette. Mais la composante normale de la force centrifuge qui s'applique dès que la roue est entrainée en rotation, tend à presser la plaquette donneuse 3 contre la surface d'accueil pour maintenir sa face arrière contre cette surface d'accueil sur toute son étendue. Cette contrainte initiale qui s'applique tant que la plaquette donneuse 3 présente une température relativement basse, proche de 1a température ambiante, tend à se réduire avec l'élévation de température qui se produit en exposant cette plaquette au faisceau d'ions. On maintient donc ce contact intime étendu, même lorsque la température s'élève, sans provoquer l'emballement thermique qui se produit dans la configuration de l'état de la technique.

La [Fig.3d] présente une variante du deuxième mode de mise en œuvre. Dans cette variante, l'élévation h de la surface d'accueil (prise au pied du support, c'est-à-dire vis-à-vis du plan principal du disque 1) est maximale au niveau de la cale 2a. Le bombé est donc tel, que la plaquette donneuse 3 au moment de son placement initial sur le support 2, présente un coté en contact avec la cale 2a et une portion de sa face arrière à proximité de ce côté en contact avec la surface d'accueil. Dans cette configuration, et lors de la mise en rotation de la roue, on maitrise la mise en butée de la plaquette donneuse 3 contre la cale 2a par effet de la force centrifuge et sa déformation. Plus précisément, la mise en contact forcé du côté de la plaquette 3 contre la cale 2a est obtenu alors que la face arrière à proximité de ce côté est bien en contact avec la surface d'accueil du support 2. La plaquette donneuse 3 peut se déformer afin de progressivement développer le contact de sa toute sa face arrière avec la surface d'accueil depuis la zone de contact initial.

Il peut être délicat de maintenir, à l'aide des clips conventionnels, la plaquette donneuse 3 dans la position représentée sur la [Fig.3d] lors de son placement initial sur le support. Aussi, et de manière avantageuse, on peut prévoir de munir le support 2 d'au moins un pion rétractable 4, comme cela est illustré sur la [Fig.3e]. Ce pion 4 présente une première extrémité destinée à entrer en contact avec la face arrière de la plaquette donneuse 3 pour contribuer à la maintenir en position. Cette première extrémité peut présenter la forme d'une sphère permettant un contact ponctuel avec la face arrière et ainsi éviter son endommagement. Le pion coopère avec un ressort 5 (ou tout autre mécanisme de maintien) afin d'être maintenu en position haute dans laquelle sa première extrémité présente une élévation correspondant sensiblement à l'élévation de la surface d'accueil au niveau de la cale 2b. La raideur du ressort 5 (ou plus généralement du mécanisme de maintien) est choisi suffisamment faible pour ne pas opposer de résistance à la déformation de la plaquette donneuse 3 lors de la mise en rotation de la roue d'implantation. Les forces de déformation s'appliquant à la plaquette donneuse tendent à rétracter le pion afin qu'il s'efface en se logeant dans le support 2, ce qui permet de mettre en contact intime la face arrière de la plaquette donneuse 3 avec la surface d'accueil de ce support.

Selon la nature des matériaux qui composent la couche épaisse et le substrat manipulateur constituant une hétérostructure donneuse, celle-ci peut se déformer différemment sous l'effet de la température. Dans une première configuration, lorsque le coefficient de dilatation thermique de la couche épaisse est supérieur à celui du substrat manipulateur, cette plaquette donneuse a tendance à se déformer en dôme dont la convexité (le sommet) est tournée du côté opposé à la face arrière. A contrario, dans une seconde configuration, lorsque le coefficient de dilatation thermique de la couche épaisse est inférieur à celui du substrat manipulateur, la plaquette donneuse à tendance à se déformer en orientant sa convexité (son sommet) du côté de la face arrière.

Dans ce mode de mise en œuvre, on choisit bien naturellement la forme bombée du support de plaquette 2 pour que celle-ci corresponde à la forme générale de la plaquette lorsque celle-ci se déforme sous l'effet de la température, c'est-à-dire que le support présente un évidemment concave ou une forme d'un dôme convexe selon la nature des matériaux formant la plaquette donneuse. Ainsi, le support de plaquette 2 représenté sur les figures 3b, 3d et 3e est particulièrement adapté à la première configuration de la plaquette donneuse, et le support de plaquette représenté sur la [Fig.3c] particulièrement adapté à la seconde configuration.

La hauteur du sommet de la forme bombée est bien naturellement dépendant de la nature des matériaux composant la plaquette donneuse, de sa dimension et de la température à laquelle elle est susceptible de recevoir sans déclencher le phénomène d'exfoliation au cours de l'étape d'implantation. Cette hauteur peut être de l'ordre du millimètre, typiquement comprise entre 0,1 mm et 5 mm.

Dans ce mode de mise en œuvre, il n'est pas absolument nécessaire de prévoir une couche élastomère, bien qu'il soit généralement très avantageux que cette couche soit présente. Lorsqu'elle est présente, cette couche ne présente pas nécessairement une dimension telle qu'elle soit en contact avec toute la face arrière de la plaquette donneuse.

Mais bien entendu, on peut combiner les deux modes de mis en œuvre et prévoir un support de plaquette 2 présentant une forme bombée munie d'une couche élastomère en contact avec toute la face arrière de la plaquette donneuse.

La forme bombée du support peut être obtenue par usinage, notamment lorsque ce support est formé d'un métal. Lorsqu'il comprend une couche élastomère superficielle, cette couche peut présenter une épaisseur variable et définir ainsi la forme bombée du support.

D'une manière plus générale, l'invention n'est pas limitée aux modes de mise en œuvre décrits et on peut y apporter des variantes de réalisation sans sortir du cadre de l'invention tel que défini par les revendications.

## Revendications

1. Equipement d'implantation ionique comprenant une source d'ions (S) et une roue d'implantation (1), l'équipement permettant de former un plan de fragilisation dans une pluralité de plaquettes donneuses, la roue comprenant un disque principal (1a) et une pluralité de supports de plaquette (2) disposés sur une face du disque principal (1a), la roue comprenant un circuit de refroidissement pour refroidir les supports de plaquette (2) et/ou le disque principal (1a), chaque support de plaquette (2) présentant une surface d'accueil destinée à recevoir une face dite « arrière » d'une plaquette donneuse (3), l'équipement étant **caractérisé en ce que** chaque surface d'accueil de la pluralité de supports de plaquette (2) présente une forme bombée, la forme bombée étant choisie pour correspondre à la forme de la plaquette donneuse (3) lorsque celle-ci se déforme sous l'effet de la température.

2. Equipement d'implantation ionique selon la revendication précédente dans laquelle chaque surface d'accueil comprend une couche d'élastomère superficielle (2b) sur laquelle repose la face arrière d'une plaquette donneuse, la couche d'élastomère superficielle présentant une dimension au moins égale à celle de la face arrière de la plaquette donneuse (3) afin de permettre la mise en contact de toute l'étendue de la face arrière de la plaquette donneuse (3) avec le support de plaquette (2).

3. Equipement d'implantation ionique selon la revendication précédente dans laquelle la couche d'élastomère superficielle (2b) présente une épaisseur variable, cette épaisseur variable définissant la forme bombée du support de plaquette (2).

4. Equipement d'implantation ionique selon l'une des revendications précédentes dans laquelle la forme bombée se présente sous la forme d'un évidemment concave ou sous la forme d'un dôme convexe.

5. Equipement d'implantation ionique selon la revendication précédente dans laquelle l'évidemment concave ou le dôme convexe présente une hauteur comprise entre 0,1mm et 5mm.

6. Equipement d'implantation ionique selon l'une des revendications précédentes présentant un axe de symétrie définissant un axe de rotation (R) et dans laquelle chaque surface d'accueil de la pluralité de supports de plaquette (2) est orientée vers l'axe de rotation (R) de sorte qu'une composante normale à la surface d'accueil de la force centrifuge s'applique à la plaquette donneuse (3) lors de la rotation de la roue et presse celle-ci contre la surface d'accueil.

7. Equipement d'implantation ionique selon l'une des revendications précédentes dans laquelle chaque support de plaquette (2) est muni d'une cale (2a) permettant de retenir une plaquette donneuse (3) en s'opposant à une composante coplanaire à la surface d'accueil de la force centrifuge s'appliquant à la plaquette donneuse (3) lors de la rotation de la roue.

8. Equipement d'implantation ionique selon la revendication précédente dans laquelle la surface d'accueil de chaque support de plaquette (2) présente une élévation, l'élévation de la surface d'accueil, par rapport au pied du support, présente un maximaum au niveau de la cale (2a).

9. Equipement d'implantation ionique selon la revendication précédente dans laquelle chaque support de plaquette (2) est muni d'un pion rétractable.

10. Equipement d'implantation ionique selon l'une des revendications 7 à 9 dans laquelle chaque support de plaquette (2) est muni d'au moins un clip permettant de positionner et retenir une plaquette contre la cale (2a).

## Patentansprüche

1. Ionenimplantationsvorrichtung, umfassend eine Ionenquelle (S) und ein Implantationsrad (1), wobei die Vorrichtung die Bildung einer Schwächungsebene in einer Vielzahl von Spenderwafern ermöglicht, wobei das Rad eine Hauptscheibe (1a) und mehrere Waferhalter (2) umfasst, die auf einer Seite der Hauptscheibe (1a) angeordnet sind, wobei das Rad einen Kühlkreislauf zum Kühlen der Waferhalter (2) und/oder der Hauptscheibe (1a) umfasst, wobei jeder Waferhalter (2) eine Aufnahmefläche aufweist, die dazu bestimmt ist, eine sogenannte "Rückseite" eines Spenderwafers (3) aufzunehmen, wobei die Vorrichtung **dadurch gekennzeichnet ist, dass** jede Aufnahmefläche der mehreren Waferhalter (2) eine gewölbte Form aufweist, wobei die gewölbte Form so gewählt ist, dass sie der Form des Spenderwafers (3) entspricht, wenn diese sich unter dem Einfluss der Temperatur verformt.

2. Ionenimplantationsvorrichtung nach dem vorstehenden Anspruch, wobei jede Aufnahmefläche eine oberflächliche Elastomerschicht (2b) umfasst, auf der die Rückseite eines Spenderwafers aufliegt, wobei die oberflächliche Elastomerschicht eine Abmessung aufweist, die mindestens derjenigen der Rückseite des Spenderwafers (3) entspricht, um den Kontakt der gesamten Fläche der Rückseite des Spenderwafers (3) mit dem Waferhalter (2) zu ermöglichen.

3. Ionenimplantationsvorrichtung nach dem vorstehenden Anspruch, wobei die oberflächliche Elastomerschicht (2b) eine variable Dicke aufweist, wobei diese variable Dicke die gewölbte Form des Waferhalters (2) definiert.

4. Ionenimplantationsvorrichtung nach einem der vorstehenden Ansprüche, wobei die gewölbte Form als konkave Vertiefung oder als konvexe Kuppel ausgebildet ist.

5. Ionenimplantationsvorrichtung nach dem vorstehenden Anspruch, wobei die konkave Vertiefung oder die konvexe Wölbung eine Höhe zwischen 0,1 mm und 5 mm aufweist.

6. Ionenimplantationsvorrichtung nach einem der vorstehenden Ansprüche mit einer Symmetrieachse, die eine Drehachse (R) definiert, und wobei jede Aufnahmefläche der mehreren Waferhalter (2) zur Drehachse (R) ausgerichtet ist, sodass eine zur Aufnahmefläche normale Komponente der Zentrifugalkraft bei der Drehung des Rades auf die Spenderwafer (3) wirkt und diese gegen die Aufnahmefläche drückt.

7. Ionenimplantationsvorrichtung nach einem der vorstehenden Ansprüche, wobei jeder Waferhalter (2) mit einem Keil (2a) versehen ist, der es ermöglicht, einen Spenderwafer (3) zu halten, indem er einer zur Aufnahmefläche koplanaren Komponente der auf den Spenderwafer (3) einwirkenden Zentrifugalkraft bei der Drehung des Rades entgegenwirkt.

8. Ionenimplantationsvorrichtung nach dem vorstehenden Anspruch, wobei die Aufnahmefläche jedes Waferhalters (2) eine Erhebung aufweist, wobei die Erhebung der Aufnahmefläche in Bezug auf den Fuß des Trägers ein Maximum auf Höhe des Keils (2a) aufweist.

9. Ionenimplantationsvorrichtung nach dem vorstehenden Anspruch, wobei jeder Waferhalter (2) mit einem rückziehbaren Stift versehen ist.

10. Ionenimplantationsvorrichtung nach einem der Ansprüche 7 bis 9, wobei jeder Waferhalter (2) mit mindestens einer Klammer versehen ist, die es ermöglicht, einen Wafer gegen den Keil (2a) zu positionieren und zu halten.

## Claims

1. An ion implantation equipment comprising an ion source (S) and an implantation wheel (1), the equipment allowing forming a plane of weakness in a plurality of donor wafers, the wheel comprising a main disc (1a) and a plurality of wafer supports (2) disposed on a face of the main disc (1a), the wheel comprising a cooling circuit for cooling the wafer supports (2) and/or the main disc (1a), each wafer support (2) having a receiving surface intended to receive a so-called "rear" face of a donor wafer (3), the equipment being **characterised in that** each receiving surface of the plurality of wafer supports (2) has a domed shape, the domed shape being selected so as to correspond to the shape of the donor wafer (3) when the latter deforms under the effect of temperature.

2. The ion implantation equipment according to the preceding claim, wherein each receiving surface comprises a surface elastomer layer (2b) on which the rear face of a donor wafer rests, the surface elastomer layer having a dimension at least equal to that of the rear face of the donor wafer (3) in order to enable the entire extent of the rear face of the donor wafer (3) to come into contact with the wafer support (2).

3. The ion implantation equipment according to the preceding claim, wherein the surface elastomer layer (2b) has a variable thickness, this variable thickness defining the domed shape of the wafer support (2).

4. The ion implantation equipment according to one of the preceding claims, wherein the domed shape is in the form of a concave recess or in the form of a convex dome.

5. The ion implantation equipment according to the preceding claim, wherein the concave recess or the convex dome has a height of between 0.1 mm and 5 mm.

6. The ion implantation equipment according to one of the preceding claims having an axis of symmetry defining an axis of rotation (R) and wherein each receiving surface of the plurality of wafers supports (2) is oriented towards the axis of rotation (R) so that a component normal to the surface receiving the centrifugal force is applied to the donor wafer (3) during rotation of the wheel and presses it against the receiving surface.

7. The ion implantation equipment according to one of the preceding claims, wherein each wafer support (2) is provided with a shim (2a) allowing holding a donor wafer (3) by opposing a component coplanar to the surface receiving the centrifugal force applied to the donor wafer (3) during rotation of the wheel.

8. The ion implantation equipment according to the preceding claim, wherein the receiving surface of each wafer support (2) has an elevation, the elevation of the receiving surface, relative to the base of the support, has a maximum at the shim (2a).

9. The ion implantation equipment according to the preceding claim, wherein each wafer support (2) is provided with a retractable pin.

10. The ion implantation equipment according to one of claims 7 to 9, wherein each wafer support (2) is provided with at least one clip allowing positioning and holding a wafer against the shim (2a).
